(19) **Europäisches Patentamt / European Patent Office / Office européen des brevets**

(11) **EP 4 686 096 A1**

(12) **EUROPEAN PATENT APPLICATION**
published in accordance with Art. 153(4) EPC

(43) Date of publication:
28.01.2026 Bulletin 2026/05

(21) Application number: 24774523.5

(22) Date of filing: 15.02.2024

(51) International Patent Classification (IPC):
$H03G\ 11/04\ ^{(2006.01)}$  $B60Q\ 5/00\ ^{(2006.01)}$
$G10K\ 15/04\ ^{(2006.01)}$  $H04R\ 3/00\ ^{(2006.01)}$

(52) Cooperative Patent Classification (CPC):
B60Q 5/00; G10K 15/04; H03G 11/04; H04R 3/00

(86) International application number:
PCT/JP2024/005367

(87) International publication number:
WO 2024/195378 (26.09.2024 Gazette 2024/39)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 21.03.2023 JP 2023044827

(71) Applicant: **Denso Electronics Corporation**
**Anjo-city, Aichi 446-8503 (JP)**

(72) Inventors:
• **YAMAMOTO, Chikara**
  **Anjo-city, Aichi 446-8503 (JP)**
• **KURIBAYASHI, Daisuke**
  **Anjo-city, Aichi 446-8503 (JP)**

(74) Representative: **Kuhnen & Wacker
Patent- und Rechtsanwaltsbüro PartG mbB
Prinz-Ludwig-Straße 40A
85354 Freising (DE)**

(54) **SOUND PRODUCTION CONTROL DEVICE**

(57) An absolute value waveform generation unit (S03) generates an absolute value waveform (Wab) obtained by converting a level (Lv) of input waveform (Win) into an absolute value when the input waveform includes an excess portion (EX) within which the absolute value of the level exceeds a limiter threshold (Th). A peak hold waveform generation unit (S04) generates a peak hold waveform (Wp) based on the absolute value waveform. A gain curve generation unit (S05) generates a gain curve (Wgn) that indicates a relationship between a gain (Gn) obtained based on a level of the peak hold waveform and input waveform time (Tm). A smoothing processing unit (S06) generates a smoothen gain curve (Wsgn) based on the gain curve by performing a smoothing processing. A sound data generation unit (S07, S08) generates sound data by multiplying a delayed input waveform (Wind) obtained by shifting the input waveform toward a positive time end (Dtp) by the smoothen gain curve.

**FIG. 2**

## Description

CROSS REFERENCE TO RELATED APPLICATION

This application is based on Japanese Patent Application No. 2023-044827 filed on March 21, 2023, the disclosure of which is incorporated herein by reference.

TECHNICAL FIELD

The present disclosure relates to a sound generation control device that controls generation of a sound to be output by a sound output unit.

BACKGROUND ART

For example, a vehicle approach notification device disclosed in Patent Literature 1 is conventionally known, and the vehicle approach notification device has a function of generating sound data to be output by a sound output unit, such as a speaker. The vehicle approach notification device described in Patent Literature 1 is mounted on an automobile, such as a hybrid automobile or an electric automobile. For example, a vehicle approach notification device may mix an approach notification sound, which notifies pedestrians around the vehicle of an approaching of the vehicle when the vehicle is traveling at a low speed, with a reverse moving warning sound, which notifies a reverse moving of the vehicle, thereby generating a mixed sound. Then, the notification device outputs, simultaneously, the multiple sounds processed into the mixed sound from a single sound output unit.

PRIOR ART LITERATURE

PATENT LITERATURE

Patent Literature 1: JP 2013-049312 A

SUMMARY

A sound generation system, such as the vehicle approach notification device in Patent Literature 1, outputs, from a sound output unit such as a speaker, a sound generated based on sound data. The vehicle approach notification device includes a digital-to-analog converter, which processes a sound signal to be input to the sound output unit, and a power amplifier. Each of the digital-to-analog converter and the power amplifier has respective input and output limits. The input and output limits are also set in the sound output unit.

In a sound generation system, a sound generation control device generates sound data while keeping the input and output signals of audio devices, such as the digital-to-analog converter, the power amplifier, and the sound output unit to be equal to or lower than the input and output limits set in advance for respective devices, thereby making effective use of the input and output limits.

For example, it is conceivable to suppress the input and output signals of the audio device to equal to or below the input and output limits by simply limiting the waveform peaks. However, when such a simple limitation of waveform peak is performed, harmonic distortion occurs due to a bend in the waveform, and an abnormal sound is generated due to the harmonic distortion. This difficulty is studied by the inventors of the present disclosure.

In consideration of the above difficulty, the present disclosure aims to provide a sound generation control device that can limit an amplitude of waveform of sound data while suppressing an abnormal sound, such as harmonic distortion caused by the amplitude limitation of the waveform.

In order to achieve the above object, according to an aspect of the present disclosure, a sound generation control device is included in a sound generation system. The sound generation control device generates sound data to be output by a sound output unit. The sound output unit outputs a sound in accordance with a sound signal prepared based on the sound data that represents a waveform of the sound. The sound generation control device includes an excess determination unit, an absolute value waveform generation unit, a peak hold waveform generation unit, a gain curve generation unit, a smoothing processing unit, and a sound data generation unit. The excess determination unit is configured to acquire an input waveform serving as a basis of the sound data, the input waveform indicating a relationship between a level corresponding to a voltage of the sound signal and time. The excess determination unit is configured to determine whether the input waveform includes an excess portion within which an absolute value of the level exceeds a predetermined limiter threshold. The absolute value waveform generation unit is configured to generate an absolute value waveform obtained by converting the level of the input waveform into an absolute value when the excess determination unit determines that the input waveform includes the excess portion. The peak hold waveform generation unit is configured to generate a peak hold waveform indicating a relationship between the level and an input waveform time by processing the absolute value waveform, the input waveform time indicating the time in the input waveform. The gain curve generation unit is configured to generate a gain curve indicating a relationship between a gain obtained based on the level of the peak hold waveform and the input waveform time. The smoothing processing unit is configured to execute a smoothing process on the gain curve to obtain a smoothen gain curve that corresponds to the gain curve. The sound data generation unit is configured to generate the sound data by multiplying a delayed input waveform by the smoothen gain curve, and the delayed input waveform is obtained by shifting the input waveform by a predetermined waveform delay time toward a positive time end in a time axis direction along which the input waveform time elapses. The peak hold waveform generation unit generates a waveform set including the absolute value waveform, a peak hold portion, and a release portion. The peak hold portion is set for each maximum point of the level in the absolute value waveform and extends linearly from the maximum point toward the positive time end by maintaining the level of the maximum point for a predetermined peak hold time until the level of the maximum point reaches the absolute value waveform. The release portion is set for each peak hold portion that extends for the peak hold time, and the release portion extends from an end of the peak hold portion located on positive time end toward a low level end with time elapse toward the positive time end until reaching the absolute value waveform. The peak hold waveform generation unit generates the peak hold waveform by extracting a shape formed on a high level end of the waveform set. In a time axis direction range where the level of the peak hold waveform is equal to or less than the limiter threshold, the gain of the gain curve is set to 1. In a time axis direction range where the level of the peak hold waveform exceeds the limiter threshold, the gain of the gain curve is set to a value obtained by a formula $Gn=Th/Lv$, where $Gn$ is the gain, $Lv$ is the level, and $Th$ is the limiter threshold. The smoothen gain curve is shifted by a predetermined gain delay time toward the positive time end by comparing respective peak portions of the gain curve and the smoothen gain curve, the peak portions indicate portions where the gain curve and the smoothen gain curve have maximum or minimum values of gains. The waveform delay time is set to be equal to or longer than the gain delay time, and the peak hold time is set to be equal to or longer than the waveform delay time.

According to the above configuration, the sound data is generated based on the input waveform. At the same time, by multiplying the delayed input waveform by the smoothen gain curve, it is possible to limit the amplitude of waveform representing the sound data to a level equal to or lower than the limiter threshold. Since the waveform of sound data after amplitude limitation is performed has a smooth shape, it is possible to suppress an abnormal sound, such as harmonic distortion caused by simple limitation of amplitude.

In some sections of the application document, some elements may be provided with reference symbols in parentheses. In this case, the reference symbol merely indicates an example of correspondence between the element and the specific configuration of the embodiment to be described later. Therefore, the present disclosure is not limited by the description of the reference symbols.

BRIEF DESCRIPTION OF DRAWINGS

FIG. 1 is a block diagram showing a general configuration of a sound generation system according to a first embodiment.
FIG. 2 is a flowchart showing a control process executed by a limiter included in the sound generation system of the first embodiment.
FIG. 3 shows a diagram of input waveform input to the limiter in (a), shows an absolute value waveform and a peak hold waveform in (b), and shows a gain curve in (c), with a common time axis of coordinate system.
FIG. 4 is a diagram showing a waveform set that is provided as a basis of the peak hold waveform and the absolute value waveform.
FIG. 5 shows a gain curve in (a) and shows a smoothen gain curve obtained by performing a smoothing process on the gain curve in (b), with a common time axis of coordinate system.
FIG. 6 shows a smoothen gain curve in (a), shows a delayed input waveform in (b), and shows a waveform represented by sound data in (c), with a common time axis of coordinate system.

DESCRIPTION OF EMBODIMENTS

The following will describe embodiments of the present disclosure with reference to the accompanying drawings. In the following embodiments including other embodiments to be described later, the same or equivalent components are denoted by the same reference symbol in the drawings.

(First Embodiment)

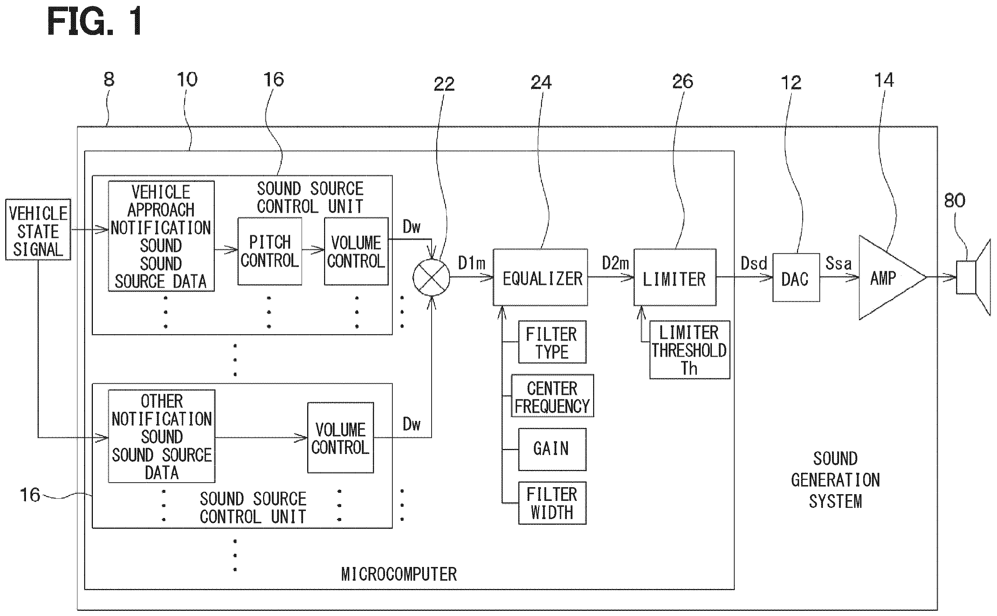

In the present embodiment, a sound generation system 8 shown in FIG. 1 is a vehicle approach notification device mounted on, for example, a hybrid vehicle or an electric vehicle. For example, the sound generation system 8 is electrically connected to a sound output unit 80, such as a speaker or a buzzer. The sound generation system 8 outputs various notification sounds from the sound output unit 80, such as a vehicle approach notification sound that notifies pedestrians around the vehicle that a vehicle equipped with the sound generation system 8 is approaching, and other notification sounds for notifying or warning users or pedestrians around ego vehicle.

The sound generation system 8 includes a microcomputer 10, a digital-to-analog converter 12, and a power amplifier 14. In the description of the present embodiment, the digital-to-analog converter 12 is also referred to as a DAC 12, and the power amplifier 14 is also referred to as an AMP 14.

The microcomputer 10 outputs the generated sound data Dsd to the DAC 12. The DAC 12 converts the sound data Dsd input from the microcomputer 10 into a sound signal Ssa, which is an analog signal, and outputs the sound signal Ssa to the AMP 14. The sound data Dsd, output waveform data DW to described later, first synthesized waveform data D1m to be described later, and second synthesized waveform data D2m to be described later are digital data representing sound waveforms (for example, PCM waveforms).

The AMP 14 supplies a current corresponding to the sound signal Ssa, which is input from the DAC 12 to the AMP 14, based on a voltage supplied from a constant voltage source (not shown). The sound output unit 80 generates a sound in response to the current being supplied from the AMP 14. The sound output unit 80 generates a sound in accordance with the sound signal Ssa based on the sound data Dsd. In the present embodiment, for example, a circuit gain of the audio circuit between the microcomputer 10 and the sound output unit 80, that is, the circuit gain of the audio circuit configured by the DAC 12 and the AMP 14, is set to be a constant value.

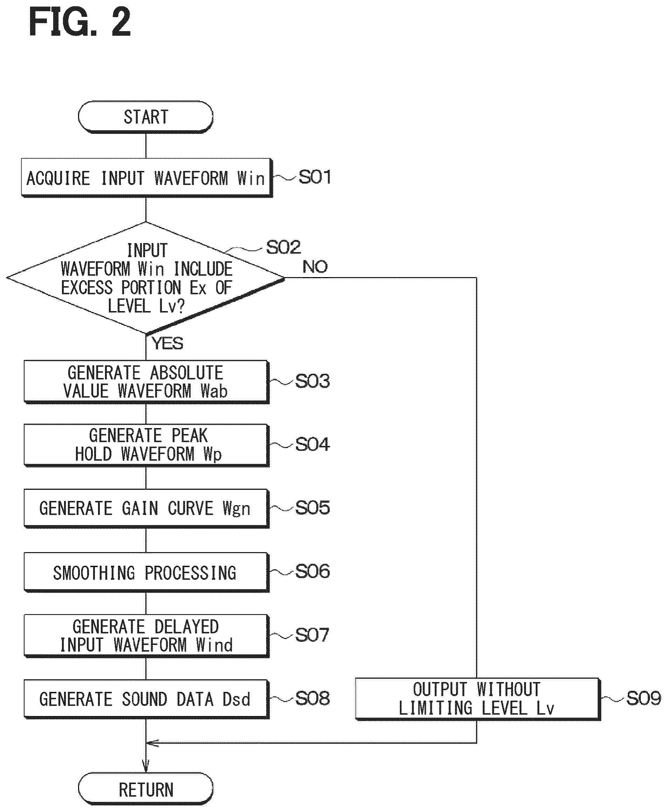

The microcomputer 10 is an electronic control device, and is configured as an on-board microcomputer including a CPU, a RAM, a ROM, a non-volatile rewritable memory, and the like (not shown). The microcomputer 10 reads out and executes a computer program stored in the ROM or the non-volatile rewritable memory, which are non-transitory tangible storage medium. A method corresponding to the computer program is performed when the computer program is executed. In the microcomputer 10, various control processes are executed according to the computer program, such as the control process shown in FIG. 2 executed by a limiter 26 included in the microcomputer 10. The details of the control process will be described later.

As shown in FIG. 1, the microcomputer 10 includes, as functional blocks, multiple sound source control units 16, a mixer 22, an equalizer 24, and a limiter 26.

Each sound source control units 16 selects, in response to a vehicle state signal, one or more sound source data from multiple pieces of sound source data stored in advance in a storage medium, such as a ROM. The sound source control unit 16 performs pitch control and volume control on each selected sound source data to generate output waveform data DW based on each selected sound source data, and outputs the output waveform data DW to the mixer 22. The vehicle state signal indicates a state of the vehicle in which the sound generation system 8 is installed (for example, the vehicle's driving condition, the remaining amount of fuel, the conditions around the vehicle, or the like), and is input to the microcomputer 10 from various sensors installed in the vehicle.

Among the multiple sound source control units 16, the sound source control unit 16, which selects sound source data to be reproduced as, for example, a vehicle approach notification sound, performs the pitch control and the volume control on the selected sound source data. The sound source control unit 16, which selects the sound source data to be reproduced as a notification sound other than the vehicle approach notification sound, performs the volume control on the selected sound source data without performing the pitch control.

The mixer 22 mixes the multiple pieces of output waveform data DW input to the mixer 22 from the multiple sound source control units 16. Then, the mixer 22 outputs a first synthesized waveform data D1m, which is the waveform data after the mixing is performed, to the equalizer 24. The mixer 22 outputs, to the equalizer 24, the first synthesized waveform data D1m, which is generated by synthesizing multiple pieces of output waveform data DW.

The equalizer 24 generates second synthesized waveform data D2m based on the first synthesized waveform data D1m by correcting audio characteristics of the first synthesized waveform data D1m, and outputs the second synthesized waveform data D2m to the limiter 26. For example, the filter characteristics of equalizer 24 is determined by defining a filter type, a center frequency, a gain, and a filter width. The change degree of second synthesized waveform data D2m relative to the first synthesized waveform data D1m varies greatly depending on the combination of the first synthesized waveform data D1m and the filter characteristics of the equalizer 24. Thus, it becomes difficult to predict an amplitude peak of the digital waveform represented by the second synthesized waveform data D2m.

The filter type may be selected by a known technology. The selectable filter type includes a low pass filter, a high pass filter, a band pass filter, a notch filter, a low shelf filter, a high shelf filter, and a peaking filter.

The limiter 26 limits the amplitude of digital waveform represented by the sound data Dsd to a predetermined limiter threshold Th or less, and outputs the amplitude-limited sound data Dsd to the DAC 12. The limiter threshold Th corresponds to the input limits of the sound output unit 80 and the AMP 14, and the limiter threshold Th corresponds to a full range of the DAC 12. For example, the limiter threshold Th may be set in advance based on experimental value. The limiter threshold Th is set as large as possible under a condition that it is possible to limit the voltage of input signal to each of the sound output unit 80 and the AMP 14 to be equal to or below the respective input limits, and to limit the waveform amplitude of sound data Dsd input to the DAC 12 within the full range of DAC 12.

In order to limit the amplitude of sound data Dsd, the limiter 26 reads, in advance, the second synthesized waveform data D2m output from the equalizer 24 before outputting the sound data Dsd to the DAC 12, and executes the control process shown in FIG. 2. The control process of FIG. 2 is repeatedly executed, for example, when the second synthesized waveform data D2m is input to the limiter 26. The limiter 26 corresponds to a sound generation control device of the present disclosure.

As shown in FIG. 2, in S01, the limiter 26 first acquires an input waveform Win to be input to the limiter 26. The input waveform Win is a digital waveform represented by the second synthesized waveform data D2m output from the equalizer 24 and to be input to the limiter 26. The input waveform Win is the basis of sound data Dsd to be output from the limiter 26 to the DAC 12. In addition to the input waveform Win, the waveforms and curves generated based on the input waveform Win in S03 to S09 to be described below are also digital waveforms.

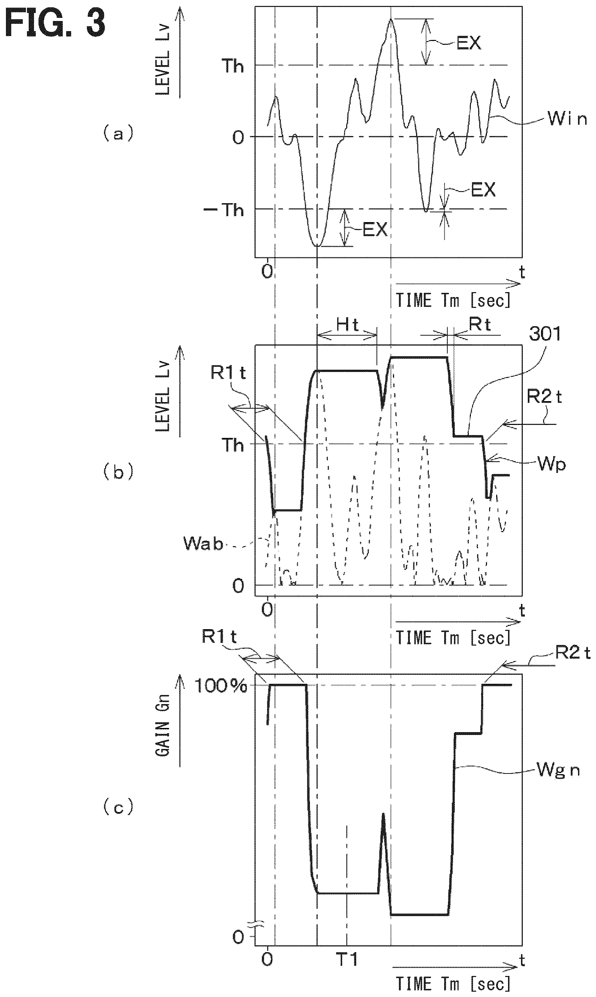

As shown in (a) of FIG. 3, the input waveform Win indicates a relationship between the level Lv and the time Tm. The level Lv corresponds to a voltage of sound signal Ssa, which is an analog signal, and the amplitude of the level Lv corresponds to the voltage amplitude of the sound signal Ssa. In the description of the present embodiment, the time Tm on the horizontal axis of the input waveform Win may also be referred to as input waveform time Tm. After executing S01 in FIG. 2, the process proceeds to S02.

In S02, as shown in (a) of FIG. 3, the limiter 26 determines whether the input waveform Win includes an excess portion EX in which the absolute value of the level Lv exceeds the limiter threshold Th. The input waveform Win shown in (a) of FIG. 3 includes three excess portions EX.

In S02 of FIG. 2, in response to determining that the input waveform Win includes the excess portion EX, the process proceeds to S03. In S02, in response to determining that the input waveform Win does not include the excess portion EX, the process proceeds to S09.

In S03, as shown in (b) of FIG. 3, the limiter 26 generates an absolute value waveform Wab by converting the level Lv on the vertical axis in the input waveform Win into the absolute value of the level Lv. The absolute value waveform Wab is a waveform obtained by inverting the negative portion of input waveform Win where the level Lv has a negative value to the positive side of the level Lv with respect to the zero position of the level Lv, and remaining the waveform of positive portion of the input waveform Win where the level Lv has a positive value. After executing S03 of FIG. 2, the process proceeds to S04.

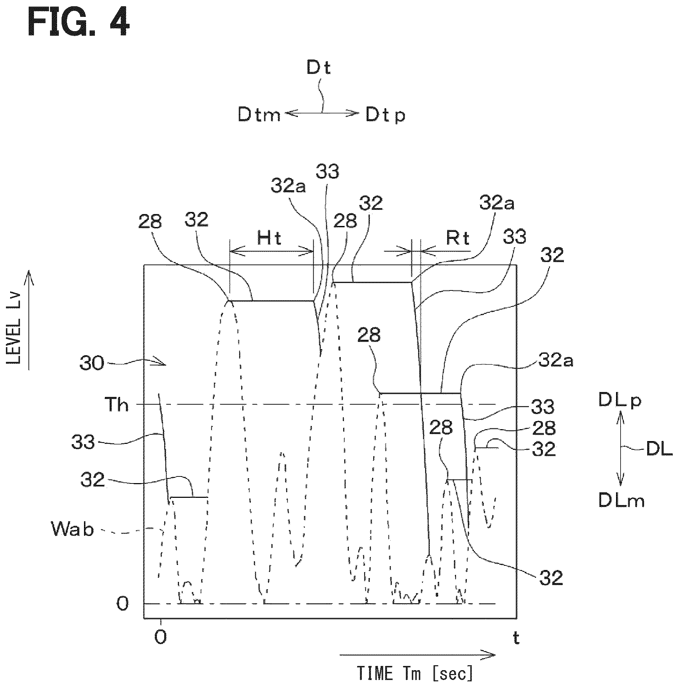

In S04, as shown in (b) of FIG. 3 and FIG. 4, the limiter 26 generates a peak hold waveform Wp indicating a relationship between the level Lv and the input waveform time Tm, based on the absolute value waveform Wab.

In the description of the present embodiment, in a coordinate system with the level Lv on the vertical axis and the input waveform time Tm on the horizontal axis, a side on which the input waveform time Tm elapses in a time axis direction Dt that is the horizontal axis, is referred to as a positive time end Dtp, and a side on which the input waveform time Tm goes back in the time axis direction is referred to as a negative time end Dtm. In the coordinate system, the high side of the level Lv in the level axis direction DL, which is the vertical axis, is referred to as a high level end DLp, and the low side of the level Lv in the level axis direction DL is referred to as a low level end DLm. The absolute value waveform Wab shown in (b) of FIG. 3 and the absolute value waveform Wab shown in FIG. 4 are the same.

To obtain the peak hold waveform Wp, the limiter 26 first generates a waveform set 30 including the absolute value waveform Wab, one or more peak hold portions 32, and one or more release portions 33, as shown in FIG. 4.

The peak hold portions 32 included in the waveform set 30 are provided for respective maximum points 28 of the level Lv in the absolute value waveform Wab. That is, the peak hold portions 32 are provided in the same number as the number of maximum points 28 of the level Lv in the absolute value waveform Wab.

Each peak hold portion 32 extends linearly from the maximum point 28 of the level Lv toward the positive time end Dtp in parallel with the time axis direction Dt. Specifically, the peak hold portion 32 extends linearly from the maximum point 28 as a start point toward the positive time end Dtp for a predetermined peak hold time Ht, while showing the same level Lv as the maximum point 28, until the peak hold portion reaches the absolute value waveform Wab.

For example, after starting the maximum point 28, when the peak hold portion 32 reaches a point of the absolute value waveform Wab before the peak hold portion extends to the peak hold time Ht, the length of peak hold portion 32 is decreased to be shorter than the peak hold time Ht. After starting the maximum point 28, when the peak hold portion 32 continues for the peak hold time Ht without intersecting with the absolute value waveform Wab, the length of peak hold portion 32 is set to a length corresponding to the peak hold time Ht. The peak hold time Ht is, for example, a constant value, and is preset as short as possible within a range in which the amplitude of waveform represented by the sound data Dsd can be limited to equal to or below the limiter threshold Th.

The release portion 33 included in the waveform set 30 is provided for each peak hold portion 32 that extends over the peak hold time Ht. The release portion 33 is provided for the peak hold portion 32 whose length in the time axis direction Dt reaches the length corresponding to the peak hold time Ht. The release portion 33 is not provided for the peak hold portion 32 whose length in the time axis direction Dt is shorter than the length corresponding to the peak hold time Ht. Therefore, the release portions 33 are provided in the same number as the peak hold portions 32 whose lengths in the time axis direction Dt reach the length corresponding to the peak hold time Ht.

The release portion 33 starts from an extended end 32a, which is the end of the peak hold portion 32 on time positive end Dtp. The peak hold portion 32 has a length corresponding to the peak hold time Ht. The release portion 33 proceeds from the extended end 32a toward the low level end DLm and the time positive end Dtp, until the release portion 33 reaches a point of the absolute value waveform Wab. The gradient of release portion 33 in the coordinate system defined by the level Lv and the input waveform time Tm may be constant, or the gradient may be increased with an increase of distance from the extended end 32a, which is the start point. The gradient of the release portion 33 is preset so as to avoid any discomfort in sound caused by limiting the amplitude of waveform represented by the sound data Dsd to be equal to or less than the limiter threshold Th.

As shown in (b) of FIG. 3 and FIG. 4, the limiter 26 extracts a high level end shape 301, which is a shape formed on the high level end DLp of the waveform set 30, which is generated as described above. The limiter 26 sets the extracted high level end shape 301 as a waveform shape of the peak hold waveform Wp. The limiter 26 determines the peak hold waveform Wp so that the waveform shape of the peak hold waveform Wp is the same as the shape of the high level end shape 301 of the waveform set 30. The peak hold waveform Wp generated in S04 is determined to have the same waveform shape as the high level end shape 301 of the waveform set 30. The time width that the release portion 33 of the peak hold waveform Wp occupies in the time axis direction Dt is referred to as a release time Rt. After executing S04 in FIG. 2, the process proceeds to step S05.

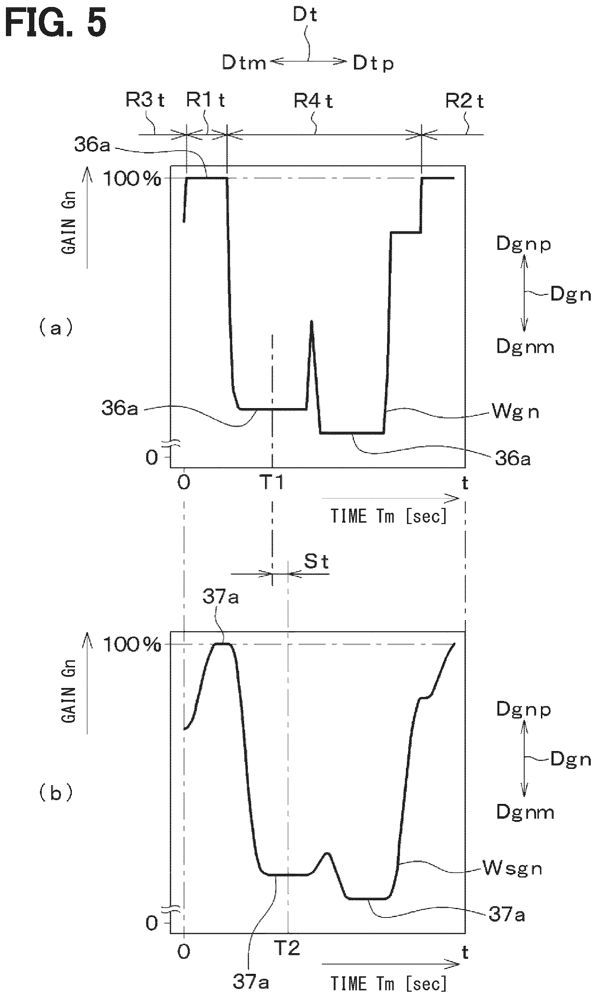

In S05, as shown in (c) of FIG. 3 and (a) of FIG. 5, the limiter 26 generates a gain curve Wgn that indicates a relationship between a gain Gn obtained based on the level Lv of the peak hold waveform Wp and the input waveform time Tm.

In the description of the present embodiment, in the coordinate system with the gain Gn on the vertical axis and the input waveform time Tm on the horizontal axis, a side with the larger gain Gn in the vertical axis direction Dgn is referred to as a large gain end Dgnp, and a side with the smaller gain Gn in the vertical axis direction Dgn is referred to as a small gain end Dgnm. In the coordinate system defined by the gain Gn and the input waveform time Tm, the direction of time axis Dt includes a positive time end Dtp and a time minus end Dtm, similar to the coordinate system defined by the level Lv and the input waveform time Tm as described above. In the description of the present embodiment and in each drawing, the gain Gn may be represented as a gain dvalue or a percentage.

The gain Gn of the gain curve Wgn is set to 1 in ranges R1t, R2t (that is, ranges R1t, R2t within the threshold Th) in the time axis direction Dt where the level Lv of peak hold waveform Wp is equal to or lower than the limiter threshold Th.

The gain Gn of the gain curve Wgn is set to a value obtained by the following mathematical formula F1 within ranges R3t, R4t (that is, ranges R3t, R4t exceeding the threshold) in the time axis direction Dt. In the ranges R3t and R4t exceeding the threshold, the level Lv of the peak hold waveform Wp exceeds the limiter threshold Th. The ranges R3t, R4t exceeding the threshold are the ranges obtained by excluding the ranges R1t, R2t within the threshold from the width of the peak hold waveform Wp in the time axis direction Dt. In the following formula F1, Gn indicates the gain Gn of gain curve Wgn, Th indicates the limiter threshold Th, and Lv indicates the level Lv in the peak hold waveform Wp. After executing S05 in FIG. 2, the process proceeds to S06.

$$Gn = Th/Lv ... (F1)$$

In S06, as shown in (a) and (b) of FIG. 5, the limiter 26 performs a smoothing process to smoothen the gain curve Wgn, thereby obtaining a smoothen gain curve Wsgn based on the gain curve Wgn. For example, the smoothing process may be performed by passing the gain curve Wgn through a double moving average filter, a Bessel filter, or a Thiran low-pass filter.

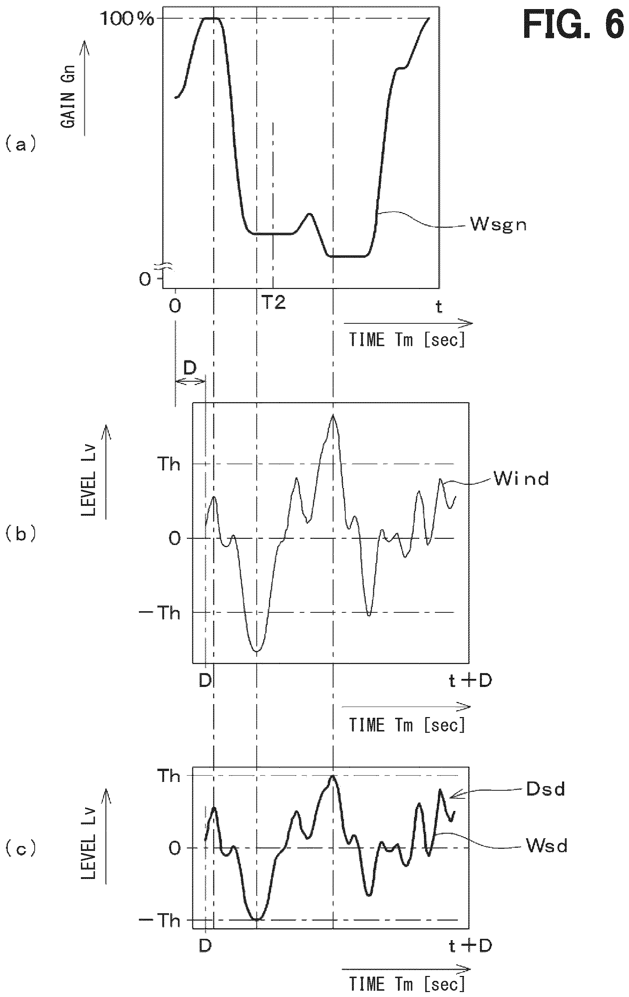

The gain curve Wgn shown in (c) of FIG. 3 is the same as the gain curve Wgn shown in (a) of FIG. 5. The smoothen gain curve Wsgn shown in (a) of FIG. 6 is the same as the smoothen gain curve Wsgn shown in (b) of FIG. 5.

The smoothen gain curve Wsgn obtained in S06 is generated by shifting, relative to the gain curve Wgn, a gain delay time St toward the positive time end Dtp by comparing the respective peak portions 36a, 37a where the gain Gn has maximum or minimum values. The gain delay time St is set to a constant value.

For example, in the time axis direction Dt, a center time T1 of one peak portion 36a included in the gain curve Wgn is compared with a center time T2 of the corresponding peak portion 37a included in the smoothen gain curve Wsgn. The peak portion 37a included in the smoothen gain curve Wsgn corresponds to the peak portion 36a included in the gain curve Wgn. In this case, the center time T2 of the peak portion 37a of the smoothen gain curve Wsgn is shifted by the gain delay time St toward the positive time end Dtp relative to the center time T1 of the peak portion 36a of the gain curve Wgn. The same applies when other peak portions 36a of the gain curve Wgn are compared with the corresponding peak portions 37a of the smoothen gain curve Wsgn. After executing S06 in FIG. 2, the process proceeds to S07.

In S07, as shown in (b) of FIG. 6, the limiter 26 generates a delayed input waveform Wind by shifting the input waveform Win toward the positive time end Dtp in the time axis direction Dt by a predetermined waveform delay time D. The waveform delay time D may be set to a constant value. The delayed input waveform Wind is a waveform obtained by parallelly shifting the input waveform Win by the waveform delay time D toward the positive time end Dtp.

The magnitude relationship between the gain delay time St, the waveform delay time D, and the peak hold time Ht is defined as St≤D≤Ht. For example, in the present embodiment, the gain delay time St, the waveform delay time D, and the peak hold time Ht are set to St=D=Ht=1 msec. After executing S07 in FIG. 2, the process proceeds to step S08.

In S08, as shown in (a) to (c) of FIG. 6, the limiter 26 generates the sound data Dsd by multiplying the delayed input waveform Wind by the smoothen gain curve Wsgn. Generating the sound data Dsd by multiplying the delayed input waveform Wind with the smoothen gain curve Wsgn means calculating a product of the level Lv of the delayed input waveform Wind and the gain Gn of the smoothen gain curve Wsgn, and setting this calculated product as the level Lv of the waveform Wsd represented by the sound data Dsd. The limiter 26 outputs, to the DAC 12, the sound data Dsd generated in S08.

By performing the process in S03 to S08 as described above, the limiter 26 can obtain the sound data Dsd in which distortion of waveform Wsd is suppressed by continuously adjusting the gain Gn while keeping the amplitude of waveform Wsd represented by the sound data Dsd to be equal to or lower than the limiter threshold Th. The waveform Wsd representing the sound data Dsd output from the limiter 26 is delayed by a waveform delay time D relative to the input waveform Win.

In S09 of FIG. 2, the limiter 26 outputs the sound data Dsd at the level Lv of the waveform Wsd, which represents the sound data Dsd, without limiting the level Lv of the input waveform Win acquired in S01.

The process executed in each step of FIG. 2 is configured as functional units which provides the corresponding function. Specifically, the process executed in S01 and S02 correspond to an excess determination unit, the process executed in S03 corresponds to an absolute value waveform generation unit, the process executed in S04 corresponds to a peak hold waveform generation unit, and the process executed in S05 corresponds to a gain curve generation unit. The process executed in S06 corresponds to a smoothing processing unit, the process executed in S07 and S08 corresponds to a sound data generation unit, and the process executed in S09 corresponds to a level non-limiting unit. The limiter 26 includes the excess determination unit, the absolute value waveform generation unit, the peak hold waveform generation unit, the gain curve generation unit, the smoothing processing unit, the sound data generation unit, and the level non-limiting unit.

As described above, according to the present embodiment, as shown in FIG. 3 and FIG. 6, when the input waveform Win includes the excess portion EX of the level Lv, the limiter 26 generates the sound data Dsd by multiplying the delayed input waveform Wind by the smoothen gain curve Wsgn.

Therefore, the sound data Dsd is generated based on the input waveform Win. At the same time, by multiplying the delayed input waveform Wind by the smoothen gain curve Wsgn, it is possible to limit the amplitude of waveform Wsd, which represents the sound data Dsd (see (c) of FIG. 6) to a value equal to or less than the limiter threshold Th. Since the waveform Wsd of sound data Dsd whose amplitude is limited is generated in smooth manner, it is possible to suppress abnormal sound such as harmonic distortion caused by the amplitude limit.

The input waveform Win input to the limiter 26 is a waveform synthesized by the mixer 22 as shown in FIG. 1, and the frequency characteristic of the waveform is corrected by the equalizer 24. Thus, it is difficult to predict the excess portion EX (see (a) of FIG. 3) of the level Lv included in the input waveform Win. Even in such a case, according to the present embodiment, the limiter 26 can generate the sound data Dsd which can suppresses abnormal sound, such as harmonic distortion while keeping the amplitude of waveform Wsd to be equal to or below the limiter threshold Th as described above.

In the present embodiment, in order to deal with a decrease in sound pressure, a duration for which the amplitude of waveform Wsd of the sound data Dsd is limited, that is, a total value obtained by adding up the gain delay time St, the peak hold time Ht, and the release time Rt, should be set to a value according to a sensitivity of a person with respect to a change in sound volume. For example, the duration for which the amplitude of waveform of the sound data is limited may be set to a value that is sufficiently smaller than the time constant of the Fast characteristic of 125 msec. For example, the total value of the gain delay time St, the peak hold time Ht, and the release time Rt may be set to 20 msec or shorter. In this way, the amplitude of only the portion of the input waveform Win that exceeds the level Lv and is in the vicinity of EX is limited for a short period of time, so that a decrease in the audio sound pressure, that is, a decrease in recognizability can be prevented.

By configuring the sound generation control device to execute the control process shown in FIG. 2, the sound generation system 8 can provide flexibility in simultaneous sound output, flexibility in correction, and reduction in product size and cost, without compromising the recognizability of notification sound.

According to the present embodiment, when the input waveform Win does not include the excess portion EX of the level Lv, the limiter 26 outputs the sound data Dsd without limiting the level Lv of the waveform Wsd represented by the sound data Dsd relative to the level Lv of the input waveform Win. Therefore, the amplitude of waveform Wsd represented by the sound data Dsd is not unnecessarily limited.

(Other Embodiments)

(1) In the above embodiment, the sound generation system 8 is described as a vehicle approach notification device mounted on an automobile. However, this is merely an example. The sound generation system 8 does not have to be a vehicle approach notification device, and various uses of the sound generation system 8 are envisioned. The sound generation system 8 does not have to be equipped to a vehicle.

(2) In the above embodiment, in S04 of FIG. 2, the limiter 26 generates the waveform set 30 shown in FIG. 4 and then generates the peak hold waveform Wp. The present disclosure is not limited to this example. Under a condition that the peak hold waveform Wp has the same waveform shape as the high level end shape 301 of the waveform set 30 (see (b) of FIG. 3), the limiter 26 does not need to generate the waveform set 30.

(3) In the above embodiment, the process shown in the flowchart of FIG. 2 is implemented by a computer program that is executed by the microcomputer 10. Alternatively, the process shown in flowchart of FIG. 2 may be implemented by a hardware circuit.

(4) The present disclosure is not limited to the above-described embodiment, and can be implemented in various modifications. Individual components or features of the above-described embodiment are not necessarily essential unless it is specifically stated that the components or the features are essential in the foregoing description, or unless the components or the features are obviously essential in principle.

The numerical value such as the number, value, quantity, range, or the like of components mentioned in the above-described embodiment is not limited to a specific number unless specified as being required, clearly limited to such a specific number in principle, or the like. The material, the shape, the positional relationship, and the like of a component or the like mentioned in the above embodiment are not limited to those being mentioned unless otherwise specified, or limited to specific material, shape, positional relationship, and the like in principle.

**Claims**

1. A sound generation control device (26) included in a sound generation system (8) and generating sound data to be output by a sound output unit (80), the sound output unit outputting a sound in accordance with a sound signal prepared based on the sound data that represents a waveform of the sound, the sound generation control device comprising:

an excess determination unit (S01, S02) configured to acquire an input waveform (Win) serving as a basis of the sound data, the input waveform indicating a relationship between a level (Lv) corresponding to a voltage of the sound signal and time (Tm), the excess determination unit further configured to determine whether the input waveform includes an excess portion (EX) within which an absolute value of the level exceeds a predetermined limiter threshold (Th);

an absolute value waveform generation unit (S03) configured to generate an absolute value waveform (Wab) obtained by converting the level of the input waveform into an absolute value when the excess determination unit determines that the input waveform includes the excess portion;

a peak hold waveform generation unit (S04) configured to generate a peak hold waveform (Wp) indicating a relationship between the level and an input waveform time (Tm) by processing the absolute value waveform, the input waveform time indicating the time in the input waveform;

a gain curve generation unit (S05) configured to generate a gain curve (Wgn) indicating a relationship between a gain (Gn) obtained based on the level of the peak hold waveform and the input waveform time;

a smoothing processing unit (S06) configured to execute a smoothing process on the gain curve to obtain a smoothen gain curve (Wsgn) that corresponds to the gain curve; and

a sound data generation unit (S07, S08) configured to generate the sound data by multiplying a delayed input waveform (Wind) by the smoothen gain curve, the delayed input waveform being obtained by shifting the input waveform by a predetermined waveform delay time (D) toward a positive time end (Dtp) in a time axis direction (Dt) along which the input waveform time elapses,

wherein

the peak hold waveform generation unit generates a waveform set (30) including the absolute value waveform, a peak hold portion (32), and a release portion (33),

the peak hold portion is set for each maximum point (28) of the level in the absolute value waveform and extends linearly from the maximum point toward the positive time end by maintaining the level of the maximum point for a predetermined peak hold time (Ht) until the level of the maximum point reaches the absolute value waveform,

the release portion (33) is set for each peak hold portion that extends for the peak hold time, and the release portion extends from an end (32a) of the peak hold portion (32) located on positive time end toward a low level end (DLm) with time elapse toward the positive time end until reaching the absolute value waveform,

the peak hold waveform generation unit generates the peak hold waveform by extracting a shape (301) formed on a high level end (DLp) of the waveform set (30),

in a time axis direction range (R1t, R2t) where the level of the peak hold waveform is equal to or less than the limiter threshold, the gain of the gain curve is set to 1,

in a time axis direction range (R3t, R4t) where the level of the peak hold waveform exceeds the limiter threshold, the gain of the gain curve is set to a value obtained by a formula $Gn=Th/Lv$, where $Gn$ is the gain, $Lv$ is the level, and $Th$ is the limiter threshold,

the smoothen gain curve is shifted by a predetermined gain delay time (St) toward the positive time end by comparing respective peak portions (36a, 37a) of the gain curve and the smoothen gain curve, the peak portions indicate portions where the gain curve and the smoothen gain curve have maximum or minimum values of gains,

the waveform delay time is set to be equal to or longer than the gain delay time, and

the peak hold time is set to be equal to or longer than the waveform delay time.

2. The sound generation control device according to claim 1, further comprising

a level non-limiting unit (S09) configured to output, in response to the excess determination unit determining that the input waveform does not include the excess portion, the sound data without limiting the level of the waveform representing the sound data, relative to the level of the input waveform.

## FIG. 1

# FIG. 2

START

ACQUIRE INPUT WAVEFORM Win — S01

INPUT WAVEFORM Win INCLUDE EXCESS PORTION Ex OF LEVEL Lv? — S02

NO

YES

GENERATE ABSOLUTE VALUE WAVEFORM Wab — S03

GENERATE PEAK HOLD WAVEFORM Wp — S04

GENERATE GAIN CURVE Wgn — S05

SMOOTHING PROCESSING — S06

GENERATE DELAYED INPUT WAVEFORM Wind — S07

GENERATE SOUND DATA Dsd — S08

OUTPUT WITHOUT LIMITING LEVEL Lv — S09

RETURN

# FIG. 3

(a)

(b)

(c)

# FIG. 4

# FIG. 5

(a)

(b)

FIG. 6

(a)

(b)

(c)

## INTERNATIONAL SEARCH REPORT

| International application No. |
|---|
| **PCT/JP2024/005367** |

**A.  CLASSIFICATION OF SUBJECT MATTER**

*H03G 11/04*(2006.01)i; *B60Q 5/00*(2006.01)i; *G10K 15/04*(2006.01)i; *H04R 3/00*(2006.01)i
FI:   H03G11/04; H04R3/00 310; G10K15/04 302F; B60Q5/00 620A; B60Q5/00 650A; B60Q5/00 660Z; B60Q5/00 630B; B60Q5/00 650B

According to International Patent Classification (IPC) or to both national classification and IPC

**B.  FIELDS SEARCHED**

Minimum documentation searched (classification system followed by classification symbols)

H03G11/04; B60Q5/00; G10K15/04; H04R3/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| A | WO 97/28599 A1 (ASAHI KASEI MICRO SYSTEMS KK) 07 August 1997 (1997-08-07) entire text, all drawings | 1-2 |
| A | JP 10-173455 A (NIPPON TELEGRAPH AND TELEPHONE CORPORATION) 26 June 1998 (1998-06-26) entire text, all drawings | 1-2 |
| A | WO 2010/005034 A1 (CLARION CO., LTD.) 14 January 2010 (2010-01-14) entire text, all drawings | 1–2 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **12 March 2024** | **26 March 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**
Information on patent family members

International application No.

**PCT/JP2024/005367**

| Patent document cited in search report | | | Publication date (day/month/year) | Patent family member(s) | | | Publication date (day/month/year) |
|---|---|---|---|---|---|---|---|
| WO | 97/28599 | A1 | 07 August 1997 | AU | 4547296 | A | |
| JP | 10-173455 | A | 26 June 1998 | US | 6107879 | A | |
| | | | | whole document | | | |
| | | | | WO | 1998/025340 | A1 | |
| | | | | EP | 944166 | A1 | |
| WO | 2010/005034 | A1 | 14 January 2010 | US | 2011/0085681 | A1 | |
| | | | | whole document | | | |
| | | | | EP | 2299590 | A1 | |
| | | | | CN | 102077464 | A | |

Form PCT/ISA/210 (patent family annex) (July 2022)

**EP 4 686 096 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023044827 A

- JP 2013049312 A